Europäisches Patentamt

European Patent Office

Office européen des brevets

(19)

(11) Numéro de publication: **0 133 408**
**B1**

(12) **FASCICULE DE BREVET EUROPEEN**

(45) Date de publication du fascicule du brevet:
29.11.89

(51) Int. Cl.⁴: **G 01 V 3/08**, B 63 G 9/06,
G 01 C 21/04, G 01 S 1/70,
B 63 B 51/00

(21) Numéro de dépôt: **84401629.5**

(22) Date de dépôt: **03.08.84**

(54) Système de trajectographie d'un bâtiment naval.

(30) Priorité: **04.08.83 FR 8312899**

(43) Date de publication de la demande:
**20.02.85 Bulletin 85/8**

(45) Mention de la délivrance du brevet:
**29.11.89 Bulletin 89/48**

(84) Etats contractants désignés:
**DE GB IT**

(56) Documents cités:
**DE-A- 1 058 648**
**FR-A- 2 354 589**
**GB-A- 2 105 135**
**US-A- 3 412 371**

**IEEE TRANSACTIONS ON GEOSCIENCE AND REMOTE SENSING, vol. GE-19, no. 4, octobre 1981, pages 235-243, IEEE, New York, US; F.H. RAAB: "Quasi-static magnetic-field technique for determining position and orientation"**

(73) Titulaire: **THOMSON-CSF, 51, Esplanade du Général de Gaulle, F-92800 Puteaux (FR)**

(72) Inventeur: **Possemé, Gilles, THOMSON-CSF SCPI 173, bld Haussmann, F-75379 Paris Cedex 08 (FR)**

(74) Mandataire: **Desperrier, Jean-Louis et al, THOMSON-CSF SCPI, F-92045 PARIS LA DEFENSE CEDEX 67 (FR)**

ACTORUM AG

## Description

La présente invention concerne un système de trajectographie permettant de suivre à l'aide de moyens magnétiques le trajet d'un bâtiment naval. Il est particulièrement utilisable pour le suivi d'un bâtiment, immunisé contre les risques de détection magnétique, notamment dans les stations de contrôle d'immunisation magnétique des bâtiments.

Une station de contrôle d'immunisation magnétique est destinée à effectuer des mesures sur un navire ou un sous-marin en mouvement au-dessus d'un alignement de capteurs, permettant, entre autres, d'ajuster les courants de boucles d'immunisation. Pour ce faire, on a besoin de localiser la position du bâtiment par rapport aux capteurs lors de chaque mesure de façon à pouvoir comparer les résultats de mesures de plusieurs passages du bâtiment.

Les progrès réalisés dans les systèmes de détection magnétique ont conduit à concevoir des systèmes d'immunisation plus performants permettant aux bâtiments d'échapper autant que possible aux systèmes de détection. Il s'ensuit une nécessité de contrôler avec une grande précision l'immunisation des bâtiments et de ce fait de pouvoir lors de tels contrôles localiser de façon très précise leur position.

Jusqu'à ces dernières années, et dans de nombreux cas encore actuellement, les moyens étaient essentiellement manuels: postes de visée soit par opérateur, soit par liaison image vidéo. Actuellement, les systèmes de positionnement et de trajectographie utilisés sont radioélectriques ou optiques; ils consistent à réaliser une triangulation à partir d'une balise mobile (sur le bâtiment) et de deux ou trois balises fixes diposées à terre.

L'ensemble est de dimensions très grandes vis-à-vis des dimensions de la base de mesure et des corrections à effectuer; en effet, le site (normalement un port) nécessite des portées de l'ordre de 4 à 5 kms.

Les précisions de positionnement réellement atteintes sont de l'ordre de 2 mètres dans les meilleurs des cas. Une telle installation est donc très grande. Elle nécessite une infrastructure (construction, alimentation, maintenance de balises) coûteuse.

Il est connu aussi d'obtenir la trajectoire d'un bâtiment de surface ou d'un sous-marin de manière acoustique. Pour cela, au moins trois capteurs acoustiques ou hydrophones sont posés et fixés sur le fond. Le bâtiment à trajectographier est équipé d'un émetteur acoustique. La mesure des instants de réception aux hydrophones du signal émis permet d'obtenir la position du mobile. Cette technique a une bonne précision de mesure, mais nécessite l'implantation d'une base acoustique (trois hydrophones) spécifique.

C'est pourquoi l'invention a pour but un système de trajectographie d'un bâtiment suffisamment précis, facilement mis en œuvre et peu coûteux.

L'invention comporte un système de trajectographie d'un bâtiment naval selon lequel le bâtiment naval comporte des moyens d'immunisation magnétiques émettant un champ magnétique d'immunisation lui permettant d'éviter des risques de détection magnétique, caractérisé en ce qu'il comprend au moins une source magnétique disposée sur le bâtiment et émettant un champ magnétique alternatif de caractéristiques connues ainsi que des moyens de détection extérieurs au bâtiment permettant de détecter le champ magnétique émis.

L'invention sera mieux comprise et d'autres caractéristiques et avantages apparaîtront à l'aide de la description qui suit en référence aux figures annexées parmi lesquelles:

– la figure 1 représente un exemple d'installation d'un système de trajectographie selon l'invention;

– les figures 2 A et 2 B illustrent les diagrammes des vecteurs d'induction de champs magnétiques du système de la figure 1;

– la figure 3 représente un exemple de réalisation de l'installation de traitement du système de l'invention;

– la figure 4 représente un exemple de réalisation d'une source magnétique embarquée sur un bâtiment.

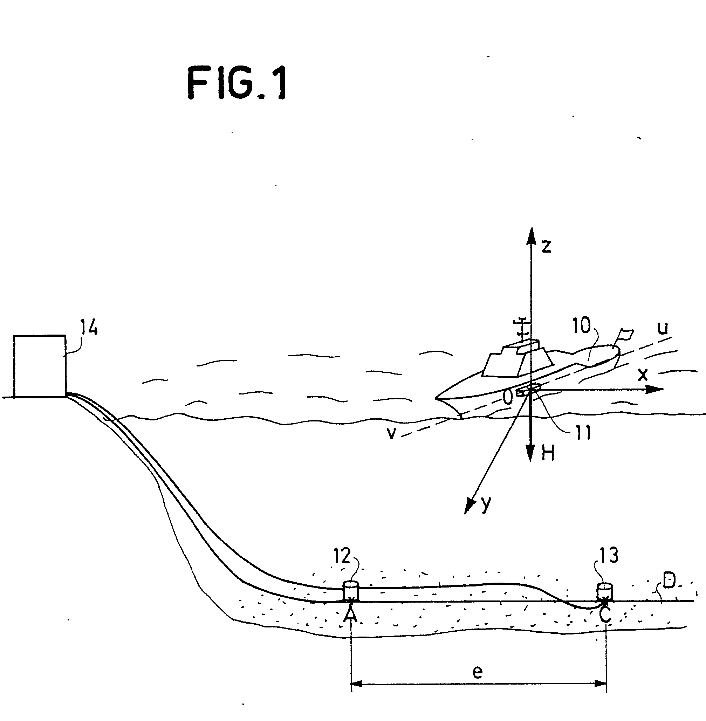

Le système de trajectographie de la figure 1 comporte une source 11 d'émission de rayonnements magnétiques fixée sur un bâtiment naval 10, deux magnétomètres 12 et 13 et une installation de traitement 14.

Le bâtiment 10 navigue, en surface par exemple, dans une zone déterminée contenue dans un plan xOy.

La source 11 émet un champ magnétique H à une fréquence connue selon une direction Oz perpendiculaire au plan xOy.

Les magnétomètres 12 et 13 peuvent être des magnétomètres directifs triaxiaux permettant de mesurer le champ magnétique selon trois directions orthogonales. Ils sont fixés au fond de la mer en des points A et C selon une droite D parallèle à l'axe Ox et à l'intérieur d'une zone correspondant à la projection, sur le fond de la mer, de la zone de navigation. Ils sont distants l'un de l'autre d'une distance e et sont orientés de façon que leurs axes de mesure soient dirigés parallèlement aux axes Ox, Oy et Oz. Chaque magnétomètre possède donc un premier axe de mesure parallèle à Ox, un deuxième axe de mesure parallèle à Oy et le troisième axe de mesure parallèle à Oz c'est-à-dire parallèle à la direction du champ magnétique H.

L'installation de traitement 14 est située à terre. Elle est reliée par des câbles de transmission d'informations aux magnétomètres et effectue les traitements appropriés d'informations fournies par les magnétomètres.

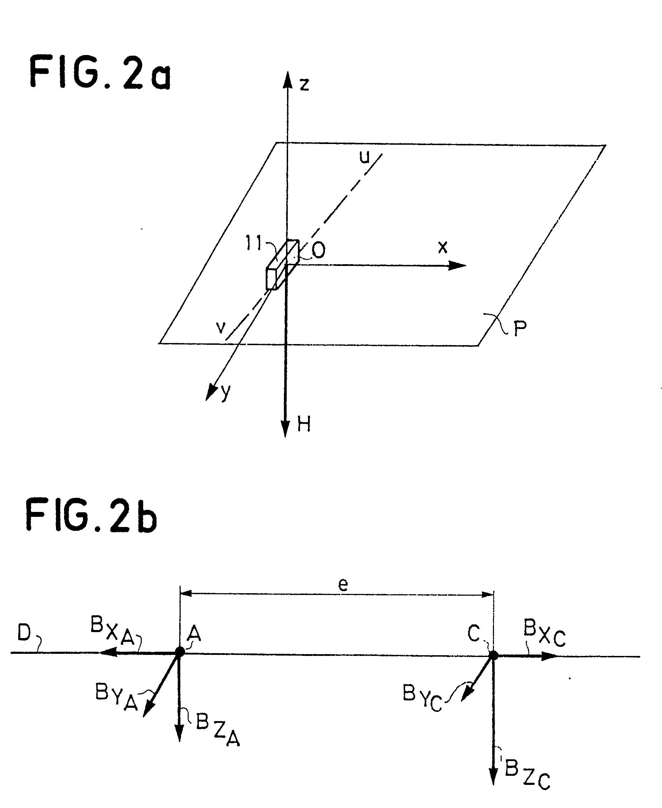

Sur les figures 2 A et 2 B illustrant les diagrammes des vecteurs d'induction magnétiques, on retrouve la source de rayonnements magnétiques 11 se déplaçant selon une direction uv dans un plan P, correspondant à la surface de la mer dans le cas d'un bateau de surface, ainsi que le trièdre Oxyz.

Les points A et C où sont situés les magnétomètres sont situés sur une droite D parallèle à l'axe Ox.

La source 11 émet un champ magnétique H perpendiculaire au plan P.

Les magnétomètres 12 et 13 mesurent aux points A et C respectivement les composantes des champs magnétiques selon trois directions parallèles aux axes Ox, Oy, Oz.

Avec l'hypothèse d'un champ dipolaire émis par la source magnétique 11, les amplitudes des composantes de l'induction B en un point de coordonnées X, Y et Z dans le trièdre Oxyz sont données par:

$$B_X = \frac{3XZ}{d^5} \cdot \frac{\mu_o M}{4\pi}$$

$$B_Y = -\frac{3YZ}{d^5} \cdot \frac{\mu_o M}{4\pi}$$

$$B_Z = \frac{2Z^2 - X^2 - Y^2}{d^5} \cdot \frac{\mu_o M}{4\pi}$$

$$d^2 = X^2 + Y^2 + Z^2$$

$\mu_o$: perméabilité,
M: moment dipolaire magnétique, En appliquant ces relations aux points A et C de coordonnées respectivement $X_A$, Y, Z et $X_C$, Y, Z, et compte tenu du fait que $X_A - X_C = e$, on obtient:

$$X_A = e \frac{B_{Y_C}}{B_{X_C}} \cdot \frac{1}{\dfrac{B_{Y_C}}{B_{X_C}} - \dfrac{B_{Y_A}}{B_{X_A}}} \qquad (1)$$

$$Y = -X_A \cdot \frac{B_{Y_A}}{B_{X_A}}$$

$$X_C = X_A - e$$

La valeur de Z est connue à partir de l'immersion des magnétomètres.

On remarque que la droite D étant parallèle à l'axe Ox, les coordonnées Y et Z des points A et C sont égales et que seules diffèrent les abscisses $X_A$ et $X_C$.

Le système de l'invention a donc permis, par la mesure des champs magnétiques en deux points A et C de déterminer leurs coordonnées par rapport à un trièdre Oxyz convenablement orienté dont le sommet O est le centre de la source d'émission 11 de rayonnements magnétiques. Dans ces conditions, connaissant les positions des points A et C il est aisé de déterminer la position du point O, donc du bateau 10.

De plus, les valeurs de $B_{Z_A}$ et de $B_{Z_C}$ n'ont pas été utilisées ce qui ne nécessite en A et C que des magnétomètres mesurant les composantes des champs magnétiques que selon deux directions Ox et Oy perpendiculaires.

Néanmoins, si les magnétomètres utilisés permettent également de mesurer les composantes des champs magnétiques selon la troisième direction Oz on pourra mettre à profit cette faculté pour effectuer les mesures lorsque le bâtiment passe à l'aplomb de la droite D. Dans ce cas-là, la coordonnée Y devient très faible puis nulle et les composantes $B_{Y_A}$ et $B_{Y_C}$ tendent vers zéro. L'équation (1) est indéterminée et on ne peut plus calculer $X_A$. Néanmoins, à partir des relations précédentes, on obtient l'équation suivante qui permet de calculer $X_A$, Z étant connu:

$$2Z^2 - \frac{3X_A Z \, B_{Z_A}}{B_{X_A}} - X_A^2 \left[ 1 + \left( \frac{B_{Y_A}}{B_{X_A}} \right)^2 \right] = 0$$

Cette équation permet par ailleurs de calculer la profondeur Z à laquelle sont immergés les magnétomètres 12 et 13. Elle est donc utilisable lorsque les mesures concernent un sous-marin immergé et dans ce cas Z est la distance qui sépare le sous-marin, du fond sur lequel se trouvent les magnétomètres 12 et 13. Elle peut servir pour affiner la mesure d'immersion en fonction de l'état de la mer et des dimensions du bâtiment.

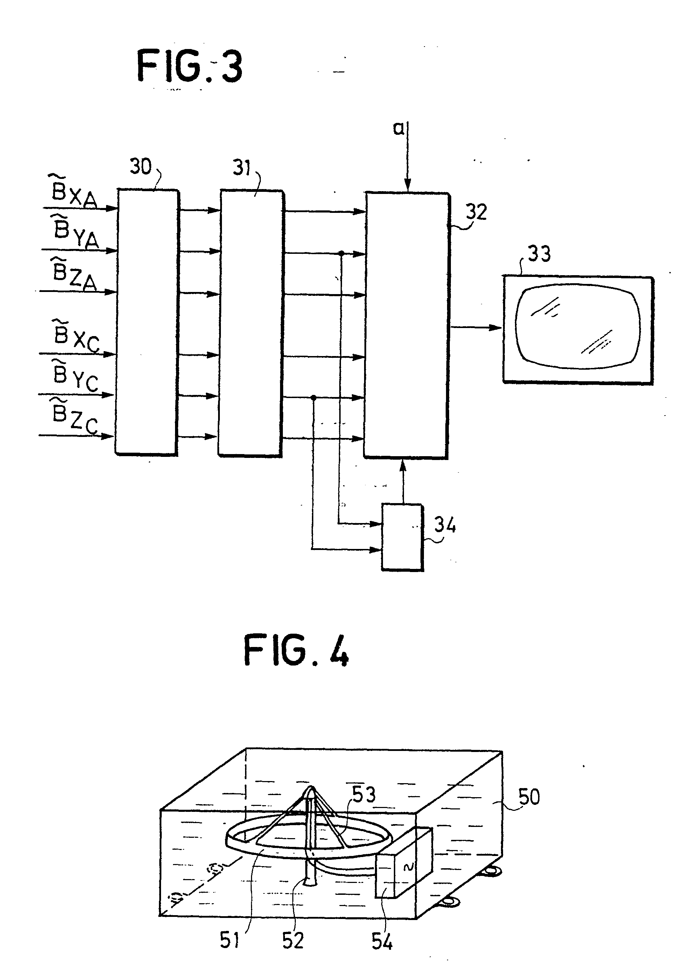

La station de mesure 14 comporte les moyens de calcul permettant d'obtenir $X_A$, Y et éventuellement Z. La figure 3 représente un schéma du traitement des signaux reçus par deux magnétomètres triaxiaux.

Un circuit de filtrage 30 reçoit les composantes des champs magnétiques aux points A et C sous forme de signaux électriques. Ces signaux sont filtrés en passe-bande autour de la fréquence de fonctionnement de la source d'émission 11. Les signaux correspondants aux composantes en A et C des champs magnétiques émis par la source 11 sont transmis à un dispositif de détection 31 qui convertit leur valeur analogique en valeur numérique. Un calculateur 32 reçoit les signaux ainsi traités. Il reçoit par ailleurs la distance e séparant les deux magnétomètres. Il calcule en échange les coordonnées $X_A$, Y, Z et affiche sur un dispositif d'affichage 33 la position du bâtiment. Un circuit test 34 détecte également à l'intention du calculateur 32 la valeur nulle de Y.

Pratiquement, un moment magnétique de $10^3 A \cdot m^2$ à une fréquence de 10 Hz permet un suivi de bâtiment sur une distance suffisante pour les besoins opérationnels (environ 100 mètres de part et d'autre de la ligne des capteurs). Par ailleurs, pour des raisons de précision de mesures, on aura intérêt de faire naviguer le bâtiment selon une ligne transverse et si possible orthogonale à la ligne D et à égale distance des magnétomètres 12 et 13.

Afin d'éviter les erreurs dues à une mauvaise verticalité du moment magnétique, ayant pour cause des mouvements de roulis-tangage, la gîte..., la source magnétique sera de préférence suspendue.

Dans l'exemple représenté sur la figure 4, cette source est une bobine 51 alimentée en courant et est enfermée dans un caisson 50 rivé sur le pont du bâtiment ou du sous-marin. La bobine 51, dont le diamètre est égal à environ 1 mètre par exemple, se trouve suspendue autour d'un axe 52 par son centre au moyen de liaisons radiales 53 inclinées vers le bas. Le caisson est rempli d'une huile isolante électriquement de manière à amortir les oscillations de la bobine et il comporte des circuits d'alimentation 54.

Suivant une autre réalisation, la source magnétique utilisée est une boucle horizontale d'immunisation dont est déjà muni le bâtiment. Le courant alternatif injecté pour produire le champ est choisi à une fréquence telle que le champ produit ne modifie pas la signature magnétique et donc ne gêne pas le réglage d'immunisation.

Dans ce cas le mobile est équipé d'un inclinomètre fournissant l'angle d'inclinaison du mobile qui est transmis à la station à terre par radio. Suivant la valeur de l'angle, le calculateur 32 calcule la position du mobile en calculant le changement d'axes nécessaire.

Enfin, les deux magnétomètres 12 et 13 peuvent être choisis parmi les magnétomètres utilisés dans la station de contrôle d'immunisation magnétique pour les mesures magnétiques. En combinaison avec la variante précédente, l'invention présente l'avantage, en utilisant le matériel existant de ne nécessiter aucune installation supplémentaire.

## Revendications

1. Système de trajectographie d'un bâtiment naval (10) selon lequel le bâtiment naval comporte des moyens d'immunisation magnétiques émettant un champ magnétique d'immunisation lui permettant d'éviter des risques de détection magnétique, caractérisé en ce qu'il comprend au moins une source magnétique (11) disposée sur le bâtiment (10) et émettant un champ magnétique alternatif de caractéristiques connues ainsi que des moyens de détection (12, 13) extérieurs au bâtiment permettant de détecter le champ magnétique émis.

2. Système de trajectographie selon la revendication 1, caractérisé en ce que les moyens de détection comportent au moins deux dispositifs de détection magnétiques (12, 13) permettant de mesurer au moins deux composantes du champ magnétique émis par la source située sur le bâtiment.

3. Système de trajectographie selon la revendication 2, caractérisé en ce que les dispositifs de détection magnétiques (12, 13) sont situés en des points fixes (A, C).

4. Système de trajectographie selon l'une des revendications 2 ou 3, caractérisé en ce que les dispositifs de détection magnétiques (12, 13) sont situés dans un plan parallèle au plan d'évolution (P) du bâtiment naval.

5. Système de trajectographie selon l'une des revendications 2 à 4, caractérisé en ce que les dispositifs de détection magnétiques (12, 13) sont disposés sur le fond marin.

6. Système de trajectographie selon l'une des revendications 1 à 5, caractérisé en ce que chaque dispositif de détection magnétique (12, 13) comporte un magnétomètre orienté de tel façon qu'il mesure au moins deux composantes du champ magnétique émis situées dans un plan parallèle au plan d'évolution (P) du bâtiment naval.

7. Système de trajectographie selon l'une des revendications 1 à 6, caractérisé en ce que chaque dispositif de détection magnétique (12, 13) comporte au moins deux magnétomètres directifs orientés selon deux axes perpendiculaires contenus dans un plan parallèle au plan d'évolution du bâtiment naval.

8. Système de trajectographie selon l'une des revendications 1 à 7, caractérisé en ce que la source magnétique comporte un solénoïde (51) alimenté en courant et constituant une boucle de courant.

9. Système de trajectographie selon l'une des revendications 1 à 8, caractérisé en ce que le solénoïde (51) est alimenté par un courant d'une fréquence déterminée.

10. Système de trajectographie selon l'une des revendications 1 à 9, caractérisé en ce que le solénoïde (51) est orienté selon une direction déterminée.

11. Système de trajectographie selon l'une des revendications 1 à 10, caractérisé en ce que le solénoïde (51) est orienté de façon à émettre un flux magnétique dont les lignes de champs sont perpendiculaires au plan (P) d'évolution du bâtiment naval.

12. Système de trajectographie selon l'une des revendications 1 à 11, caractérisé en ce que le solénoïde (51) comporte des moyens de suspension (52, 53) permettant de garder le solénoïde dans une même position par rapport au plan horizontal.

13. Système de trajectographie selon l'une des revendications 1 à 12, caractérisé en ce qu'il comporte des moyens d'amortissement des mouvements du solénoïde.

14. Système de trajectographie selon l'une des revendications 1 à 13 dans lequel le bâtiment naval est immunisé par des boucles de compensation de champ magnétique contre les risques de détection magnétique, caractérisé en ce que la source magnétique est formée par au moins une ou boucle de compensation alimentée par un courant alternatif d'une fréquence déterminée.

15. Système de trajectographie selon l'une des revendications 1 à 14, caractérisé en ce que les moyens de détection (12, 13) sont fournis par les moyens de détection d'une station de réglage d'immunisation.

## Claims

1. A trajectographic system for tracking a vessel (10), in which the vessel comprises magnetic immunisation means which emit a magnetic immunisation field, enabling the vessel to avoid the risk of being detected magnetically, characterized in that the system includes at least one magnetic source (11) disposed on the vessel (10) and emitting an alternating magnetic field of known characteristics, as well as detection means (12, 13) away from the vessel and allowing the emitted magnetic field to be detected.

2. A trajectographic system according to claim 1, characterized in that the detection means comprise at least two magnetic detector devices (12, 13) conceived to measure at least two components of the magnetic field emitted by the source located on the vessel.

3. A trajectographic system according to claim 2, characterized in that the magnetic detection devices (12, 13) are located at fixed points (A, C).

4. A trajectographic system according to claim 2 or 3, characterized in that the magnetic detection devices (12, 13) are located in a plane parallel to the manoeuvring plane (P) of the vessel.

5. A trajectographic system according to one of claims 2 through 4, characterized in that the magnetic detection devices (12, 13) are disposed on the sea bottom.

6. A trajectographic system according to one of claims 1 through 5, characterized in that each magnetic detection device (12, 13) comprises a magnetometer which is so directed that it will measure at least two components of the emitted magnetic field which are located within a plane parallel to the manoeuvring plane (P) of the vessel.

7. A trajectographic system according to one of claims 2 through 6, characterized in that each magnetic detection device (12, 13) comprises at least two directional magnetometers, which are directed according to two perpendicular axes, that are contained within a plane parallel to the manoeuvring plane of the vessel.

8. A trajectographic system according to one of claims 1 through 7, characterized in that the magnetic source comprises a solenoid (51) fed by an electric current and constituting a current loop.

9. A trajectographic system according to one of claims 1 through 8, characterized in that the solenoid (51) is fed by current having a predetermined frequency.

10. A trajectographic system according to one of claims 1 through 9, characterized in that the solenoid (51) is oriented according to a predetermined direction.

11. A trajectographic system according to one of claims 1 through 10, characterized in that the solenoid (51) is directed such as to emit a magnetic flux, whose field lines extend perpendicularly to the manoeuvring plane (P) of the vessel.

12. A trajectographic system according to one of claims 1 through 11, characterized in that the solenoid (51) comprises suspension means (52, 53) allowing to maintain the solenoid in a same position relative to the horizontal plane.

13. A trajectographic system according to one of claims 1 through 12, characterized in that it comprises damping means for attenuating the movements of the solenoid.

14. A trajectographic system according to one of claims 1 through 13, in which the vessel is immunized by means of loops suitable for compensating the magnetic field against the risks ob being detected magnetically, characterized in that the magnetic source is constituted of at least one compensation loop, which is fed by alternating current of a predetermined frequency.

15. A trajectographic system according to one of claims 1 through 14, characterized in that the detection means (12, 13) are supplied by the detection means of an immunisation control station.

**Patentansprüche**

1. System zur Erfassung der Fahrstrecke eines Schiffes (10), das magnetische Mittel zur Immunisierung aufweist, die ein magnetisches Immunisierungsfeld zur Vermeidung der Gefahr einer magnetischen Ortung ausstrahlen, dadurch gekennzeichnet, daß das System mindestens eine am Schiff (10) angebrachte und ein magnetisches Wechselfeld bekannter Charakteristik ausstrahlende magnetische Quelle (11), sowie außerhalb des Schiffes Detektormittel (12, 13) zur Erfassung des ausgesandten magnetischen Feldes aufweist.

2. Streckenerfassungssystem nach Anspruch 1, dadurch gekennzeichnet, daß die Erfassungsmittel mindestens zwei magnetische Detektorvorrichtungen (12, 13) aufweisen, die die Messung mindestens zweiter Komponenten des von der am Schiff angebrachten Quelle ausgestrahlten Magnetfelds erlauben.

3. Streckenerfassungssystem nach Anspruch 2, dadurch gekennzeichnet, daß die magnetischen Detektorvorrichtungen (12, 13) an festen Punkten (A, C) angebracht sind.

4. Streckenerfassungssystem nach einem der Ansprüche 2 oder 3, dadurch gekennzeichnet, daß die magnetischen Detektorvorrichtungen (12, 13) in einer Ebene parallel zur Bewegungsebene (P) des Schiffes angebracht sind.

5. Streckenerfassungssystem nach einem der Ansprüche 2 bis 4, dadurch gekennzeichnet, daß die magnetischen Detektorvorrichtungen (12, 13) am Gewässerboden angebracht sind.

6. Streckenerfassungssystem nach einem der Ansprüche 1 bis 5, dadurch gekennzeichnet, daß jede der magnetischen Detektorvorrichtungen (12, 13) ein Magnetometer aufweist, das so orientiert ist, daß es mindestens zwei Komponenten des ausgestrahlten magnetischen Feldes mißt, welche in einer Ebene parallel zur Bewegungsebene (P) des Schiffes liegen.

7. Streckenerfassungssystem nach einem der Ansprüche 1 bis 6, dadurch gekennzeichnet, daß jede der magnetischen Detektorvorrichtungen (12, 13) mindestens zwei gerichtete Magnetometer aufweist, die nach zwei zueinander senkrechten Achsen in einer parallel zur Bewegungsebene des Schiffes liegenden Ebene orientiert sind.

8. Streckenerfassungssystem nach einem der Ansprüche 1 bis 7, dadurch gekennzeichnet, daß die Magnetquelle eine Spule (51) aufweist, die mit Strom gespeist wird und eine Stromschleife bildet.

9. Streckenerfassungssystem nach einem der Ansprüche 1 bis 8, dadurch gekennzeichnet, daß die Spule (51) mit einem Strom bestimmter Frequenz gespeist wird.

10. Streckenerfassungssystem nach einem der Ansprüche 1 bis 9, dadurch gekennzeichnet, daß die Spule (51) in eine bestimmte Richtung orientiert ist.

11. Streckenerfassungssystem nach einem der Ansprüche 1 bis 10, dadurch gekennzeichnet, daß die Spule (51) derart orientiert ist, daß sie einen magnetischen Fluß mit Feldlinien senkrecht zur Bewegungsebene (P) des Schiffes ausstrahlt.

12. Streckenerfassungssystem nach einem der Ansprüche 1 bis 11, dadurch gekennzeichnet, daß die Spule (51) Aufhängemittel (52, 53) aufweist, die es gestatten, die Spule in einer festen Lage bezüglich der waagrechten Ebene zu halten.

13. Streckenerfassungssystem nach einem der Ansprüche 1 bis 12, dadurch gekennzeichnet, daß es Mittel zum Dämpfen der Bewegungen der Spule aufweist.

14. Streckenerfassungssystem nach einem der Ansprüche 1 bis 13, bei dem das Schiff durch Schleifen zur Kompensierung des Magnetfeldes gegen die Gefahr der magnetischen Ortung immunisiert ist, dadurch gekennzeichnet, daß die magnetische Quelle aus mindestens einer Kompensationsschleife besteht, die mit einem Wechselstrom bestimmter Frequenz gespeist wird.

15. Streckenerfassungssystem nach einem der Ansprüche 1 bis 14, dadurch gekennzeichnet, daß die Detektormittel (12, 13) von den Detektormitteln einer Station zur Immunisationsregelung geliefert werden.

# FIG.1

# FIG.2a

# FIG.2b

# FIG. 3

$$\widetilde{B}_{X_A}$$

$$\widehat{B}_{Y_A}$$

$$\widehat{B}_{Z_A}$$

$$\widetilde{B}_{X_C}$$

$$\widehat{B}_{Y_C}$$

$$\widetilde{B}_{Z_C}$$

a

30

31

32

33

34

# FIG. 4

50

53

51

52

54